# EUROPÄISCHE PATENTANMELDUNG

(11) **EP 0 829 819 A2**
(43) Veröffentlichungstag der Anmeldung: **18.03.1998**
(21) Anmeldenummer: 97115783.9
(22) Anmeldetag: 11.09.1997
(51) Int. Cl.: G06K 19/07

(54) **Chipkarte zur kontaktlosen Kommunikation in Form eines mehrschichtigen Kartenkörpers**

(30) Priorität: 13.09.1996 DE 19637306
(71) Anmelder: Orga Kartensysteme GmbH, 33104 Paderborn (DE)
(72) Erfinder: Fischer, Dirk, Dr., 33106 Paderborn (DE); Fannasch, Lothar, 33647 Bielefeld (DE)

(57) **Zusammenfassung**

Die Erfindung bezieht sich auf ein Verfahren zur Herstellung einer Chipkarte in Form eines mehrschichtigen Kunststoff-Kartenkörpers (1) bestehend aus
- einer Spulenträgerschicht ( 10A) mit einer darauf angeordneten Spule (10A0) sowie Anschlußstellen (Spulenenden, 10A1 ) zur elektrischen Kontaktierung der Spule (10A0) mit einem Chipmodul (2),
- einer vorderseitigen, auf der Spulenträgerschicht (10A) spulenseitig angeordneten Deckschicht (10B) mit einer Aussparung (10B0) zur Aufnahme des Chipmoduls (2), wobei die Lage und Größe der Aussparung (10B0) so ausgebildet ist, daß die An schlußstellen (10A1) der Spule (10A0) innerhalb der Aussparung (10B0) liegen,
- einer rückseitigen auf der Spulenträgerschicht (10A) angeordenten Kartenschicht (Stabilisatorschicht,11),
wobei ein Zwischenerzeugnis (10), bestehend aus
- der Spulenträgerschicht (10A) mit der darauf angeordneten Spule (10A0) und den Anschlußstellen (10A1) zur elektrischen Kontaktierung der Spule (2) mit dem Chip modul (2)
- und der, auf der Spulenträgerschicht (10A) angeordneten, vorderseitigen Deckschicht (10B),
in den Formraum (33) einer Spritzgußform (3) eingelegt wird, dessen Dimensionierung der des zu fertigenden Kartenkörpers (1) entspricht, wobei das Zwischenerzeugnis (10) mit der vorderseitgen Deckschicht (10B) an einem der beiden großflächigen Wandbereiche (31A) des Formraumes (33) anliegt,
und in das verbleibende Restvolumen des Formraumes (33) schmelzflüssiges Kunststoffmaterial für die rückseitige Kartenschicht (Stabilisatorschicht, 11) zur Ausbildung des fertigen Kunststoff-Kartenkörpers (1) eingespritzt wird.

## Beschreibung

Die Erfindung bezieht sich auf eine Chipkarte zur kontaktlosen bzw. kontaktlosen und kontaktbehafteten Kommunikation mit entsprechenden Terminals, wobei die Chipkarte als mehrschichtiger Kartenkörper aufgebaut ist. Eine derartige Chipkarte ist in der DE 195 05 245 beschrieben. Die dort beschriebene Chipkarte besteht aus einem mehrschichtigen Kartenkörper, der eine innere Kartenschicht (Antennen-/Spulenträgerschicht) aufweist, auf der eine Spule mit ihren Anschlußstellen (Spulenenden) zur elektrischen Kontaktierung der Spule mit einem Chipmodul angeordnet ist, wobei auf die Spulenträgerschicht zur Ausbildung einer fertigen Karte zu beiden Seiten jeweils eine Kunststoffplatte aufgeklebt wird. Zur Aufnahme des Chipmoduls weisen die vordere Kunststoffplatte und die Spulenträgerschicht jeweils eine Aussparung auf. Unter Verwendung eines derartig aufgebauten Kartenkörpers kann das Chipmodul nachträglich in den bereits fertiggestellten Kartenkörper eingesetzt werden. Dies hat den Vorteil, daß das vergleichsweise teuere Chipmodul nur in qualitaiv als gut befundene Kartenkörper eingeseztzt wird. Anderenfalls, wenn das Chipmodul unmittelbar bei der Herstellung des Kartenkörpers unlösbar in diesen implantiert wird, sind die Ausschußkosten, die dann bei einer fehlerhaften Kartenkörperherstellung entstehen, deutlich größer.

Nun gibt es bereits Zwichenerzeugnisse zur Herstellung der oben beschriebenen Chipkarte mit Spule zur induktiven Daten- und Energieübertragung auf dem Markt, die beispielsweise von Leiterplattenherstellern produziert werden. Ein derartiges Zwischenerzeugnis besteht aus der Spulenträgerschicht mit der darauf angeordneten Spule und den Anschlußstellen zur elektrischen Kontaktierung der Spule mit dem Chipmodul und einer auf der Spulenträgerschicht angeordneten vorderseitigen Deckschicht (vorderseitige Kunststoffplatte). Die Spule ist dabei vorzugsweise aus einer elektrisch leitend beschichteten Kunststoffolle geätzt, welche auf die Spulenträgerschicht aufkaschiert wird. Die so kaschierte Spulenträgerschicht mit Spulen-/Antennenfolle hat eine Dicke von ca. 100 bis 150 µm. Auf diese flexible Spulenträgerschicht wird dann spulenseitig zur Ausbildung des Zwischenerzeugnisses die vorderseitige Deckschicht mit der Aussparung zur Aufnahme des Chipmoduls in einem Kaschier-/Laminationsprozeß aufgebracht. Die Dicke der Deckschicht liegt etwa in der Größenordnung der Spulenträgerschicht. Damit ist das Zwischenerzeugnis mechanisch noch sehr flexibel. Um einen Kartenkörper gemäß dem ISO-Standard 7810 mit einer Normdicke von 760 µm zu erhalten, wird dieses Zwischenerzeugnis beim weiterverarbeitenden Kartenhersteller mit einer rückseitigen Kartenschicht in einem Kaschier-/Laminationsprozeß versehen, was jedoch sehr zeitaufwendig und kostenintensiv ist.

Aufgabe der Erfindung ist die daher die Schaffung eines kostengünstigen, rationellen und zuverlässigen Verfahrens zur Herstellung von Chipkarten, welche eine Spule zum induktiven Daten-und Energieaustausch enthalten.

Diese Aufgabe wird erfindungsgemäß durch die kennzeichnenden Merkmale des Patenanspruches 1 gelöst. Die sich daran anschließenden Unteransprüche enthalten vorteilhafte Ausführungsformen des Verfahrens.

Erfindungsgemäß wird das Zwischenerzeugnis, bestehend aus
der Spulenträgerschicht mit der darauf angeordneten Spule und den Anschlußstellen zur elektrischen Kontaktierung der Spule mit dem Chipmodul und der auf der Spulenträgerschicht angeordneten vorderseitigen Deckschicht,
in den Formraum einer Spritzgußform eingelegt, dessen Dimensionierung der des zu fertigenden Kartenkörpers nach ISO 7810 entspricht, wobei das Zwischenerzeugnis mit der vorderseitgen Deckschicht an einem der beiden großflächigen Wandbereiche des Formraumes anliegt. In das verbleibende Restvolumen des Formraumes wird dann schmelzflüssiges Kunststoffmaterial für die rückseitige Kartenschicht (Stabilisatorschicht) zur Ausbildung des fertigen Kunststoff-Kartenkörpers eingespritzt. Auf diese Weise ist es möglich, die Zwischenerzeugnisse mit einem großen Sückdurchsatz in rationeller und zuverlässiger Weise zu verarbeiten. Die Haftung zwischen der Spulenträgerschicht und der angespritzen, rückseitigen Kartenschicht ist dabei sehr gut.

An Hand der beigefügten Zeichnungen soll die Erfindung nachfolgend näher erläutert werden. Es zeigt:
- Fig.1: einen Schnitt durch den mehrschichtigen Kartenkörper vor dem Einsetzten des Chipmoduls in einer Ausführungsform ohne Aussparung für das Chipmodul in der angespritzten, rückseitigen Deckschicht,
- Fig.2: wie in Fig.1, jedoch mit eingesetztem (implantierten) Chipmodul,
- Fig.3: einen Schnitt durch den mehrschichtigen Kartenkörper vor dem Einsetzten des Chipmoduls in einer Ausführungsform mit einer Aussparung für das Chipmodul auch in der angespritzten, rückseitigen Deckschicht,
- Fig.4: wie in Fig.3, jedoch mit eingesetztem (implantierten) Chipmodul,
- Fig.4A: wie in Fig.4, jedoch mit einer zwischen der Antennenträgerschicht und einer rückseitigen, bedruckten Deckschicht eingespritzten Stabilisatorschicht,
- Fig.5: eine Draufsicht auf die sichtbare Oberfläche des in den Kartenkörper eingesetzten Chipmoduls,
- Fig.6: eine Draufsicht auf einen Kunststoff-Substratträger zur Herstellung des Chipmoduls,
- Fig.7: eine Draufsicht auf die Rückseite des Chipmoduls,
- Fig.8: eine Draufsicht auf eine Chipkarte mit eingesetztem Chipmodul,
- Fig.9: eine Draufsicht auf die Chipkarte wie in Fig.8, jedoch ohne eingesetztes Chipmodul, so daß die Spule und die Ansschlußstellen der Spule an das Chipmodul sichtbar sind,
- Fig.10: eine Draufsicht auf die Antennenträgerschicht,
- Fig.11: eine Schnittdarstellung durch den Kartenkörper und das einzusetzende Chipmodul entlang der Schnittlinie A-A -vgl. Fig.5 u.7,
- Fig.12: eine Schnittdarstellung durch den Kartenkörper und das einzusetzende Chipmodul entlang der Schnittlinle B-B -vgl. Fig.5 u.7,
- Fig.13: einen Schnitt durch ein Spritzgußwerkzeug zur Herstellung des erfindungsgemäßen Kartenkörpers gemäß Fig.3,
- Fig.14: einen Schnitt durch ein Spritzgußwerkzeug zur Herstellung des erfindungsgemäßen Kartenkörpers wie in Fig.13, jedoch mit zwei gegeneinander verschiebbaren Stempeln,
- Fig.15: einen Schnitt durch ein Spritzgußwerkzeug zur Herstellung des erfindungsgemäßen Kartenkörpers mit tiefgezogener Antennenträgerschicht,
- Fig.16: einen Schnitt durch ein Spritzgußwerkzeug mit auseinandergefahrenen Formhälften, wobei der eine Wandbereich einen einstückig mit diesem verbundenen zweistufigen Stempel aufweist,
- Fig.17: eine schematische Darstellung des Verfahrens unter Verwendung von auf einer Rolle angeordneten Zwischenerzeugnissen mit einer automatischen Zuführung.

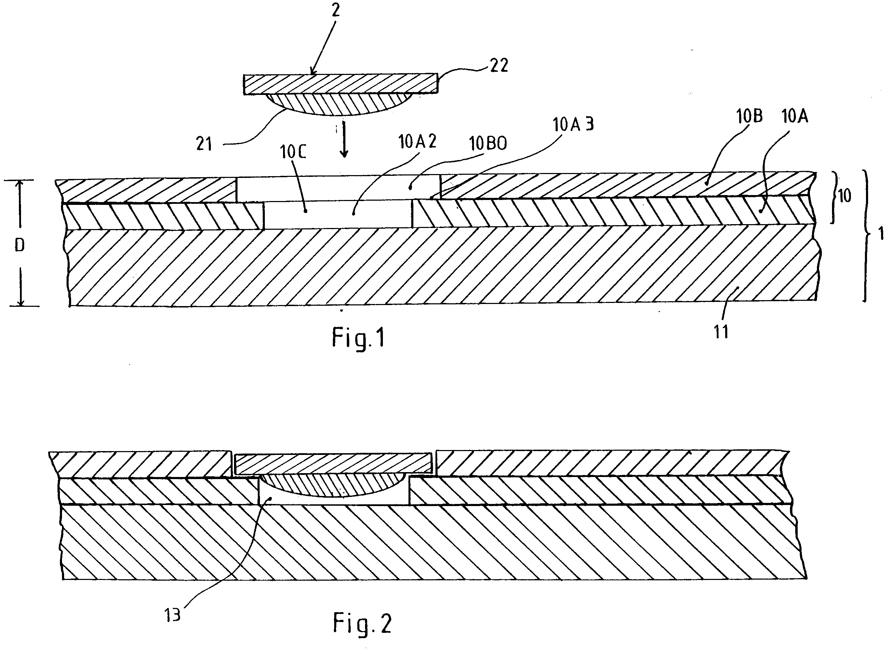

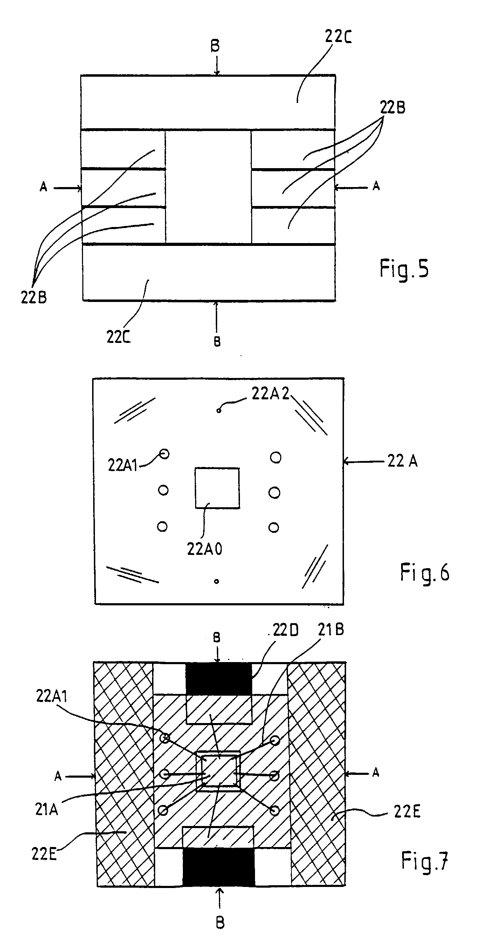

In den Fig. 1 bis 4A ist schematisch der Aufbau des Kunststoffkartenkörpers (1) und des Chipmoduls (2) dargestellt. Details von Chipmodul (2) und Spulenträgerschicht (10A) sind hier aus Gründen der Übersicht nicht mit eingezeichnet. Für Details wird auf die Fig. 5 bis 12 verwiesen.
Zunächst wird zum besseren Verständnis an Hand der Fig. 1 bis 12 der Aufbau der erfindungsgemäß hergestellten mehrschichtigen Chipkarte beschrieben. Die verfahrensrelevanten Erläuterungen erfolgen dann mit Bezug auf die Zeichnungsfig. 13 bis 16, in denen Spritzgußwerkzeuge/Formen zur Durchführung des Verfahrens gezeigt sind.

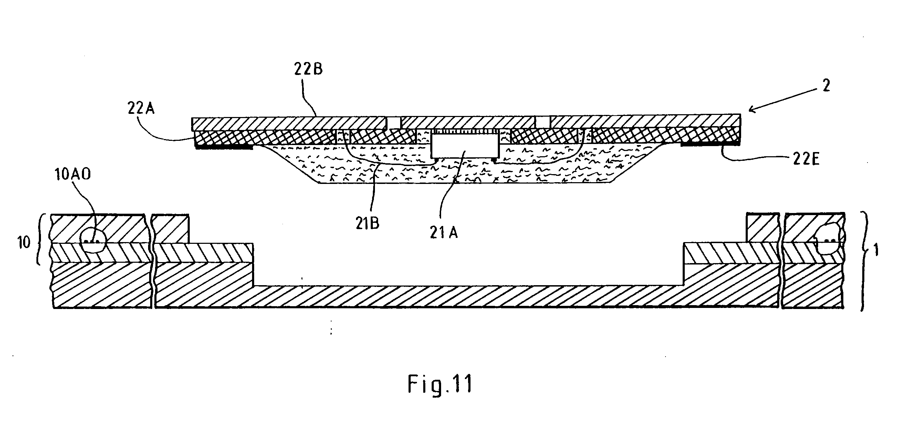

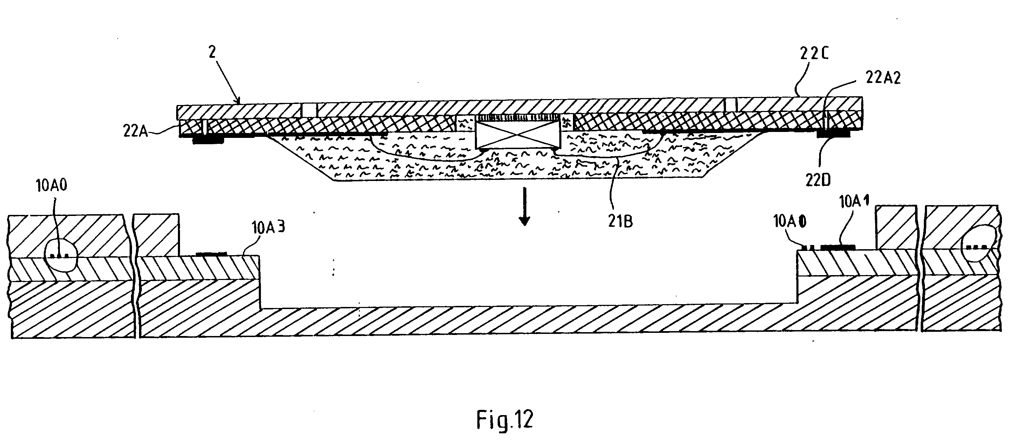

Fig.1 zeigt eine erste Ausführungsform des fertigen Kunststoff-Kartenkörpers. Auf der Vorderseite der Spulenträgerschicht (10A), d.h. auf der Seite auf der die Spule (10A0) sich befindet, ist die Deckschicht (10B) als vorderseitige Kartenschicht angeordnet. Das Aufbringen der Deckschicht (10B) in einem Kaschier-/Laminationsprozeß erfolgt unter Ausbildung des Zwischenerzeugnisses (10) in einem separaten Arbeitsgang, beispielsweise beim Leiterplattenhersteller, welcher auch die Spulenträgerschicht (10A) herstellt. Deckschicht (10B) und-Spulenträgerschicht (10A) weisen eine zweistufige Vertiefung (10C) zur Aufnahme des Chipmoduls (2) auf, wobei die zweistufige Vertiefung (10C) von einer Aussparung (10B0) in der Deckschicht (10B) und einer mittig dazu liegenden, kleineren Aussparung (10A2) in der Spulenträgerschicht (10A) gebildet ist. Die Aussparung (10A2) in der Spulenträgerschicht (10A) kann bereits in diese hinein gestanzt sein oder aber durch Taschen-Fräsen des fertigen Kartenkörpers (1) geschaffen werden. Auf der der Spule abgewandten Seite der Spulenträgerschicht (10A) befindet sich die erfindungsgemäß angespritzte, rückseitige Kartenschicht (11), die dem mehrschichtigen Kartenkörper (1) die notwendige Stabilität und Dicke, vorzugweise nach ISO 7810 verleiht.
Das Chipmodul (2) besteht prinzipiell aus zwei Teilen, nämlich einem ersten Teil (21) in Form eines Gußgehäuses (z.B. strahlungshärtende Vergußmasse) zum Schutz vor mechanischen Belastungen, das den Chip und die Anschlußleitungen (s. Fig.11 und 12) aufnimmt und einem zweiten Teil (22), das als Trag-und Verankerungsteil über den ersten Teil (21) hinausragt. Das implantierte Chipmodul (2) liegt mit dem, über das Gußgehäuse (21) hinausragenden Bereich des Trag-und Verankerungsteils (22), auf dem als Auflageschulter (10A3) dienenden Abschnitt der Spulenträgerschicht (10A) innerhalb der zweistufigen Vertiefung (10C). Die beiden elektrisch leitenden Anschlußstellen, die zur Verbindung des IC-Bausteins mit den Spulenenden dienen, befinden sich auf der Rückeite des Trag-und Verankerungsteils (22). Diese Anschlußstellen ragen beispielsweise als metallische Kontaktfahnen aus dem Gußgehäuse (21) heraus. Innerhalb des Gußgehäuses (21) ist der IC-Baustein beispielsweise über Bonddrähte mit den Kontaktfahnen verbunden. Die Anschlußstellen am Chipmodul sind korrespondierend zu Anschlußstellen (Spulenenden) auf der Spulenträgerschicht (10A) innerhalb der zweistufigen Vertiefung (10C) angeordnet. Die Anschlußstellen am Chipmodul (2) und an der Spule sind beispielsweise mittels eines leitfähigen Klebers, durch Ultraschallschweißen, durch Löten oder durch Widerstandsschweißung miteinander elektrisch leitend verbunden. Das Chipmodul (2) ist vorzugsweise noch mit Hilfe eines Klebers (z.B. eine Heißklebeschicht) stabilisierend gehalten. Der Kleber befindet sich auf dem noch freien Randbereich des Trag-und Verankerungsteils (22) außerhalb des Gußgehäuses (21). Das Einkleben des Chipmoduls (2) in den Kartenkörper (1) und die elektrisch leitfähige Kontaktierung des Chipmoduls (2) mit den Spulenenden erfolgt vorzugsweise in einem Arbeitsschritt. Auf einem Hybridmodul, das zusätzlich zur kontaktosen Betriebsart eine kontaktbehaftete Betriebsart ermöglicht, befinden sich auf der Vorderseite des Trag-und Verankerungstelis (22), die von den rein kontaktbehaftet arbeitenden Chipkarten bekannten, Kontaktflächen. Diese Kontaktflächen sind ihrereseits wiederum in bekannter Weise innerhalb des Gußgehäuses beispielsweise über Bondrähte mit dem IC-Baustein verbunden.

Fig.2 zeigt den Kartenkörper aus Fig.1, jedoch mit implantiertem Chipmodul (2). Das Chipmodul (2) liegt mit der Oberfläche des Trag-und Verankerungsteils (22) bündig mit der vorderseitigen Deckschicht (10B) oder minimal gegenüber versetzt (± 0,1mm). Auf der Rückseite ist das Chipmodul (2) mit seinem Gußgehäuse (21) von einem Luftspalt (13) in der zweistufigen Vertiefung (10C) umgeben. Dies ist bereits von rein kontaktbehafteten Chipkarten bekannt und hat den Vorteil, daß beim Biegen der Karte keine oder nur sehr geringe Kräfte auf den unter dem schützenden Gußgehäuse (21) liegenden IC-Baustein und seine Anschlußleitungen übertragen werden.

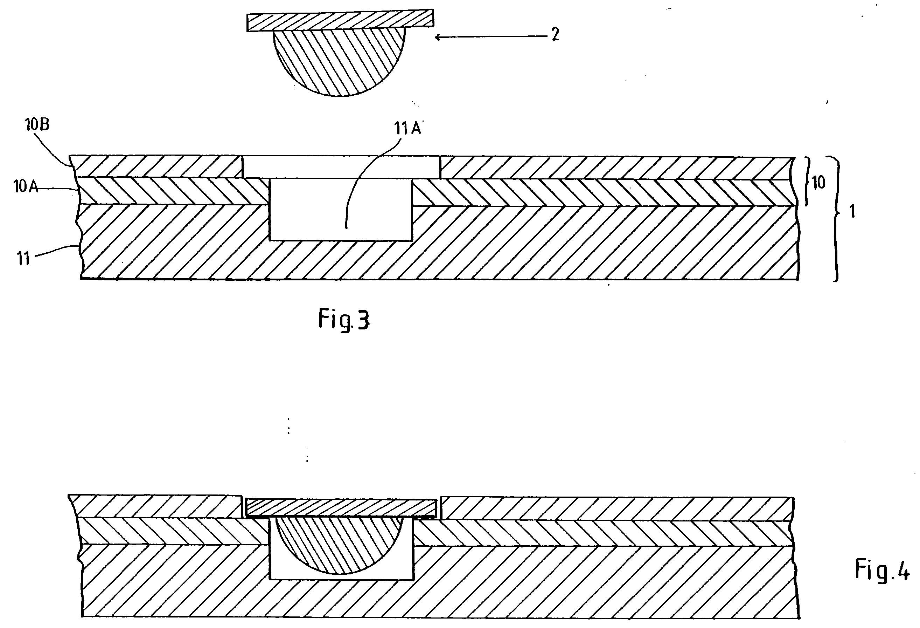

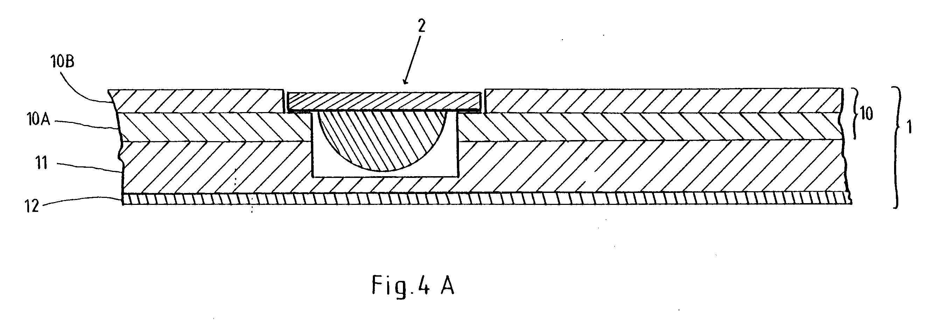

Fig.3 und Fig.4 zeigen grundsätzlich das gleiche wie Fig.1 und 2, jedoch mit dem Unterschied, daß das Gußgehäuse (21) des Chipmoduls (2) größer, insbesondere höher ist, so daß zur Aufnahme desselben eine zusätzliche Vertiefung (11A) in der angespritzten, rückseitigen Kartenschicht (11) vorhanden ist. Auch hier ist das Chipmodul (2) mit seinem Gußgehäuse (21) von einem Luftspalt (13) in der zweistufigen Vertiefung (10C) umgeben. Die zusätzliche Vertiefung (11A) in der angespritzen, rückseitigen Kartenschicht (11) wird vorzugsweise durch entsprechende Ausgestaltung des Formraumes unmittelbar beim Spritzgußprozeß hergestellt. Hierin liegt ein wesentlicher Vorteil der erfindungsgemäß hergestellten Karte gegenüber der gemäß DE 195 05 245 hergestellten Karte. Bei der dort geoffenbarten Karte muß die rückseitig aufgeklebte Kunststoffplatte zur Aufnahme größerer Chipmodule eine sacklochartige Vertiefung aufweisen. Die Herstellung einer solchen Kunststoffplatte ist im Vgl. zur Herstellung einer Kunststoffplatte mit einem lichten Loch, bei der ein Stanzvorgang reicht, relativ aufwendig. Im Unterschied hierzu ist beim erfindungsgemäßen Verfahren überhaupt kein zusätzlicher Arbeitsschritt notwendig, wenn die Ausgestaltung des Formraumes unmittelbar die Vertiefung erbringt. Allerdings ist es auch möglich, einen erfindungsgemäß hergestellten Kartenkörper (), bei dem auf eine entsprechende Ausgestaltung des Formraumes verzichtet wurde, nach dem Spritzgußvorgang zur Ausbildung einer entsprechenden Vertiefung aufzufräsen.

Fig.4A zeigt eine Chipkarte, die im wesentlichen der aus Fig.4 entspricht, allerdings ist die Dicke der angespritzten Kartenrückseite () zugunsten einer darauf angeordneten Overlay-Folie (12) reduziert, so daß die Geamtdicke (D) der Karte nach wie vor der Normdicke entspricht. Die Overlay-Folie (12), die ebenso wie die vorderseitige Deckschicht (10B) bedruckt sein kann, wird vorzugsweise im Spritzgußvorgang mit der Spulenträgerschicht (10A) verbunden, wobei das schmelzflüssige Kunststoffmaterial in das Restvolumen des Formraumes zwischen Spulenträgerschicht (10A) und Overlay-Folie (12) eingespritzt wird.

Fig.5 zeigt eine Draufsicht auf das Chipmodul (2), das in diesem Fall ein Hybridmodul ist. Zu erkennen sind die Kontaktflächen (22B) korrespondierend zu den Normkontaktflächen gemäß ISO 7816-2. Daneben sind in dieser beispielhaften Ausführungsform Metallflächen (22C) angeordnet, die der Wärmeleitung zu den, auf der Rückseite des Trag-und Verankerungsteils (22) des Chipmoduls (2) befindlichen, metallischen Anschlußstellen (22D) zur Verbindung mit den Spulenenden dienen (z.B. durch einen Lötprozeß).

Fig.6 zeigt die Draufsicht auf ein Kunststoff-Substrat (22A) auf dem die Kontaktflächen (22B) und die beiden weiteren Metallflächen (22C) angerordnet sind. Das Kunststoff-Substrat (22A) ist damit der wesentliche Bestandteil des Trag-und Verankerungsteils (22) vom Chipmodul (2). Das Kunststoff-Substrat (22A) weist eine zentrale Ausstanzung (22A0) für den IC-Baustein (21A) und Zuführöffnungen (22A1) für die Bonddrähte (21B) zwischen dem IC-Baustein (21A) und den Kontaktflächen (22B) auf. Darüber hinaus weist das Kunststoff-Substrat (22A) zwei Öffnungen (22A2) zur metallisch leitenden Durchkontaktierung zwischen den Anschlußstellen (22D) des Chipmoduls (2) für die Spulenenden und den korrespondierenden Metallflächen (22C) zur Wärmeleitung beim Lötprozeß auf. Die Metallisierung des Kunststoff-Substrats (22A) erfolgt vorzugweise galvanisch.

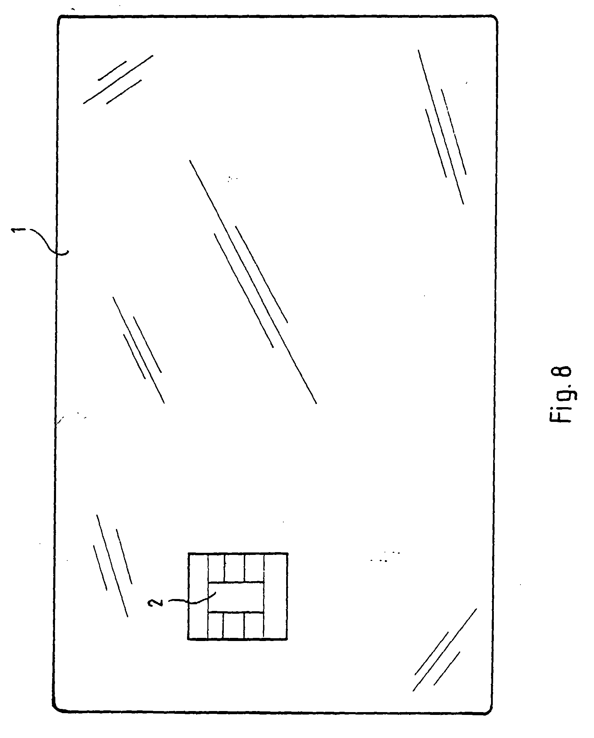

Fig.7 zeigt die Unteransicht des Chipmoduls (2). Die das Gußgehäuse (21) bildende Vergußmasse wurde schraffiert eingezeichnet, so daß der IC-Baustein (21A), die Bondrähte (21B) und die als Kontaktfahnen ausgebildeten und teilsweise unter der Vergußmasse (21) liegenden Anschlußstellen (22D) für die Spulenenden sichtbar sind. Auf den das Gußgehäuse (21) links und rechts in Fig.7 überragenden Abschnitten des Trag-und Verankerungsteils (22) ist jeweils eine Heißklebeschicht (22E) aufgebracht, die der anschließenden Fixierung des Chipmoduls (2) im Kartenkörper dient.

Fig.8 zeigt eine Draufsicht auf die Vorderseite der Chipkarte mit eingesetztem Chipmodul (2).

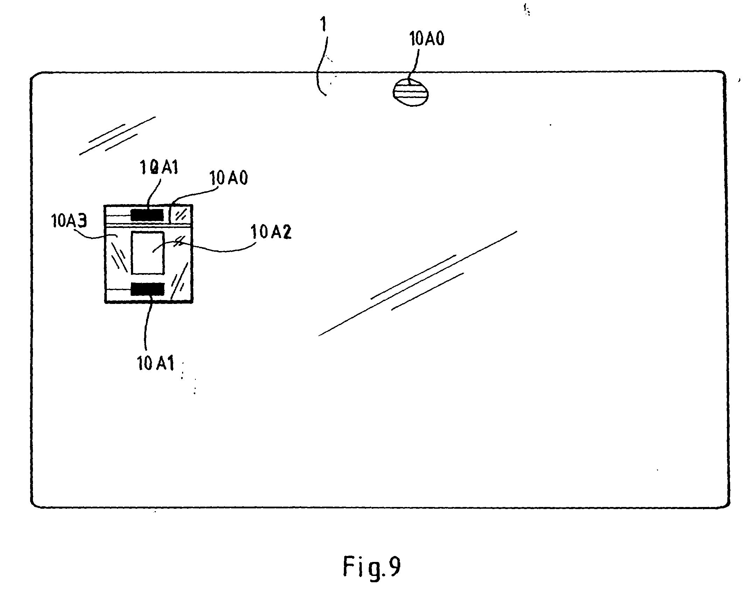

Fig.9 zeigt eine Draufsicht auf den Kartenkörper ohne eingesetztes Chipmodul. Zu erkennen ist die zweistufige Vertiefung (10C), die Leiterbahnen (10A0) der Spule sowie die Spulenenden mit den Anschlußstellen (10A1) zur elektrischen Kontaktierung mit den korrespondierenden Ansschlußstellen (22D) des Chipmoduls (2). Die Deckschicht (10B) über ist an einer Stelle aufgebrochen dargestellt, um den randseitigen Verlauf der Spulenleiterbahnen (10A0) zu verdeutlichen.

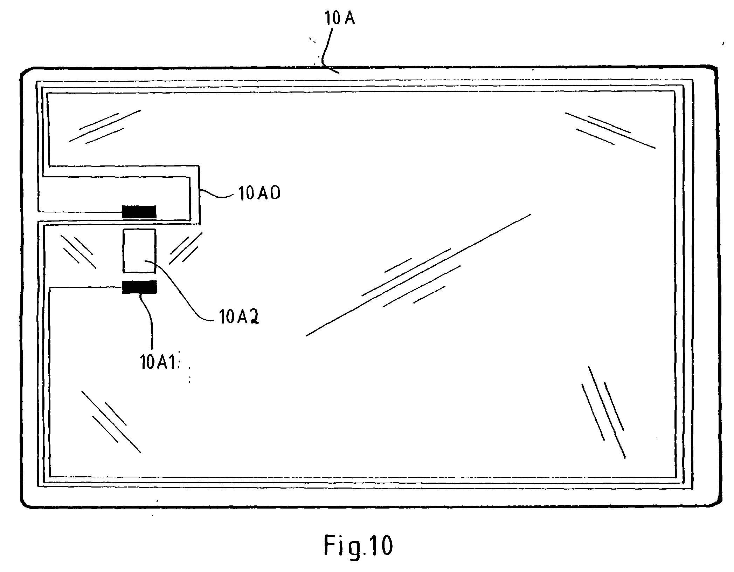

Fig.10 zeigt die Draufsicht auf die Spulenträgerschicht (10A) ohne darüber befindlicher Deckschicht.

Fig.11 zeigt einen Schnitt durch den Kartenkörper (1) und das Chipmodul (2) entlang der Linie A-A (vgl. Fig.5 und 7) in Explosinsdarstellung. Mit Hilfe der Heißklebeschicht (22E) auf dem Trag- und Verankerungsteil (22) wird das Chipmodul (2) auf der Auflageschulter (10A3) der zweistufigen Vertiefung (10C) fixiert. Spulenträgerschicht (10A) und Deckschicht (10B) sind an zwei Stellen aufgebrochen dargestellt, um die Spulenleiterbahnen (10A0) sichtbar zu machen.

Fig.12 zeigt einen Schnitt entlang der Linie B-B. Zu erkennen sind die Anschlußstellen (22D) am Chipmodul (2) und die Anschlußstellen (Spulenenden, 10A3) auf der Spulenträgerschicht (10A) sowie die dort verlaufenden Leiterbahnen (10A0) der Spule. Die eigentlichen Anschlußstellen (22D) am Chipmodul (2) sind im Bereich, wo die Anschlußstellen (10A3) der Spule (10A0) liegen, etwas erhöht ausgebildet beispielsweise durch einen Lötüberzug oder durch einen leitfähigen Kleber, wenn eine andere Variante der Verbindungstechnik verwendet wird. Der Lötüberzug oder der leitfähige Kleber können sich jedoch ebenso gut auf den Anschlußstellen (10A3) der Spule befinden. Eine technische zur Optimierung von Widerstandsschweißung ist beispielsweise Zinn.

Die nachfolgend erläuterten Spritzgußwerkzeuge sind nicht maßstabsgetreu dargestellt.

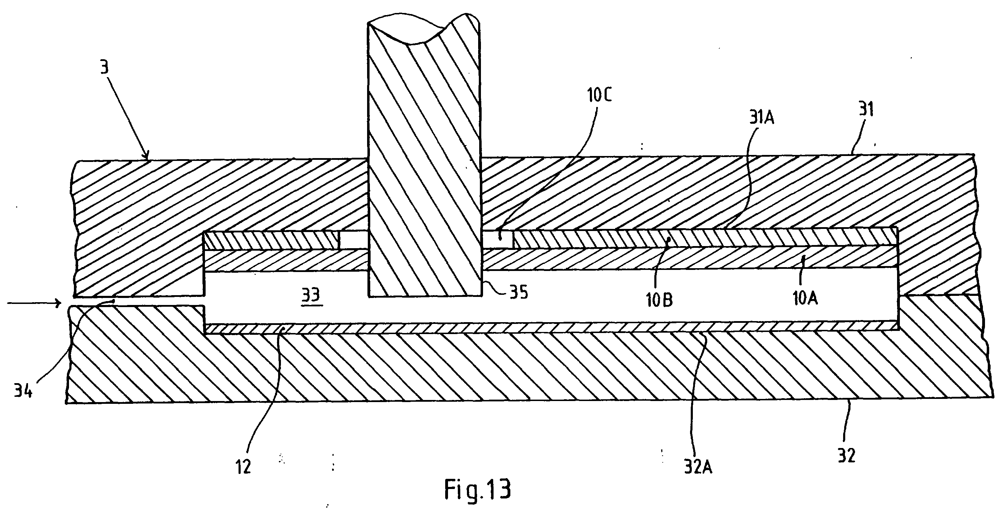

Fig. 13 zeigt einen Schnitt durch ein Spritzgußwerkzeuge zur Durchführung des erfindungsgmäßen Verfahrens. Die den Formraum (33) bildende Spritzgußform (3) besteht aus zwei auseinanderfahrbaren Hälften (31,32), die mit ihren Wandbereichen (31A,32A) den quaderförmigen Formraum (33) begrenzen und einen seitlichen Einspritzkanal (34) für das schmelzflüssige Kunststoffmaterial bilden. Die Dimensionierung des Formraumes (33) entspricht der des zu fertigenden Kartenkörpers, vorzugsweise nach ISO-7810. Das Zwischenerzeugniss (Spulenträgerschicht + Deckschicht) wird bei geöffneter Spritzgußform (3) mit der vorderseitigen Deckschicht (10B), an einem der beiden großflächigen Wandbereiche (31A) anliegend, angeordnet. Anschließend wird die Spritzgußform geschlossen und in das verbleibende Restvolumen des Formraumes (33) das schmelzflüssige Kunststoffmaterial eingespritzt. In den Formraum (33) hinein ragt ein Stempel (35), dessen Länge im Formraum (33) in dem hier gezeigten Fall größer als die Dicke (D) des Zwischenerzeugnisses (Spulenträgerschicht + Deckschicht) ist. Der Stempel (35) ist mit seiner Querrschnittsfläche so dimensioniert, daß er die durch die Aussparung (10A2) in der Spulenträgerschicht (10A) gebildete Öffnung verschließt, so daß das, in das verbleibende Restvolumen eingespritzte, schmelzflüssige Kunststoffmaterial nicht in den dahinter liegenden Bereich der Vertiefung (10C) eindringen kann. Aufgrund der Länge des Stempels (35) wird gleichzeitig die gewünschte sacklochartige Vertiefung (11A) in der angespritzten Kunststoffschicht (11) erzielt. Vorzugsweise ist es vorgesehen, den Stempel (35) parallel zur Kartennormale verschiebar gegenüber der Spritzgußform (3) auszubilden. Damit lassen sich in einfacher Weise verschiedene Vertiefungen (11A) ausbilden. Auch ist es somit möglich, den Stempel (35) während des Spritzgußvorganges in seiner Position zu verändern. So ist es vorzugsweise vorgesehen, daß der Stempel (35) zu Beginn des Einspritzvorganges nur geringfügig gegenüber der Spulenträgerschicht (10A) vorsteht oder nahezu bündig mit dieser abschließt. Damit wird die Ausbildung einer Bindenaht infolge des Umströmens der mit hoher Geschwindigkeit einströmenden, schmelzflüssigen Kunststoffmasse um den Stempel () als Strömungswiderstand vermieden. Die Verschlußfunktion des Stempels (35) bleibt jedoch gewahrt. Die Vertiefung (11A) in der angespritzten Kartenschicht (11) erfolgt dann, indem der Stempel (35) vor dem vollständigen Befüllen des Formraumes mit der eingespritzten Kunststoffmasse in diese hinein gepresst wird. Die Stirnseite des dargestellten Stempels (35) ist zwar plan, jedoch sind auch gewölbte Stirnflächen vorgesehen, um eine andere Ausgestaltung der Vertiefung (11A) zu erzielen.
In Fig. 13 ist gezeigt, wie sich auf dem großflächigen Wandbereich (32A) der anderen Formhälfte (32) eine Overlay-Folie (12) befindet. Die schmezflüssigen Kunststoffmasse wird in den Raum zwischen Overlay-Folie (12) und Spulenträgerschicht (10A) eingespritzt.

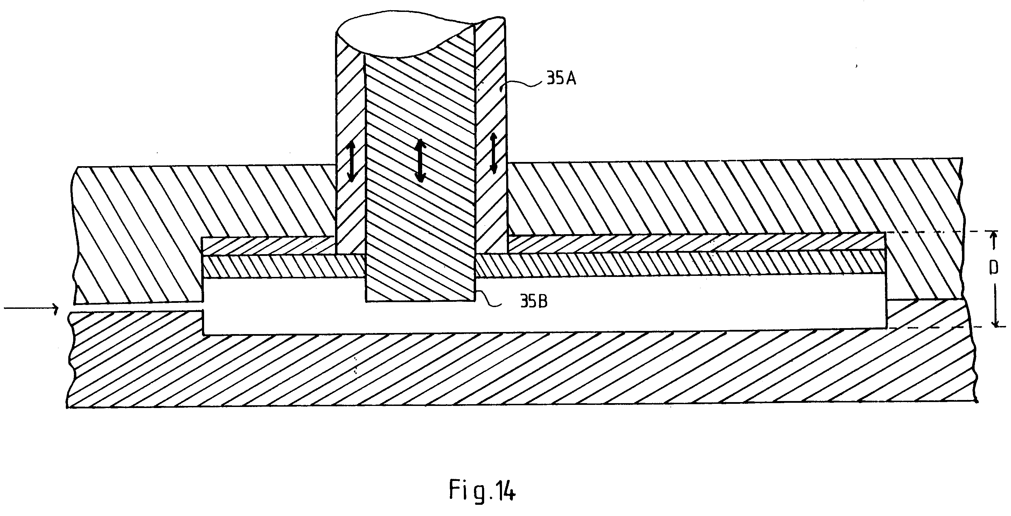

Fig.14 zeigt einen zweistufig, entsprechend der zweistufigen Vertiefung (10C) in dem Zwischenerzeugnis (10) ausgebildten Stempel (35). Dabei handelt es sich um zwei ineinander gleitende Stempel (35A,35B). Die Stirnfläche des ersten, äußeren Stempels (35A) liegt bei eingelegtem Zwischenerzeugnis (10) zur Abstützung auf der freiliegenden Spulenträgerschicht (10A) innerhalb der zweistufigen Vertiefung (10C). Damit wird verhindert, daß die Spulenträgerschicht (10A) in diesem Bereich von der unter großem Druck eingespritzten, schmelzflüssigen Kunststoffmasse eingedrückt wird. Der zweite, innenliegende Stempel (35B) verhindert, daß die schmelzflüssige Kunststoffmasse in den Bereich der zweistufigen Vertiefung (10C) eindringt, und erbringt gleichzeitig die gewünschte Vertiefung (11A) in der angespritzten Kartenschicht (11).

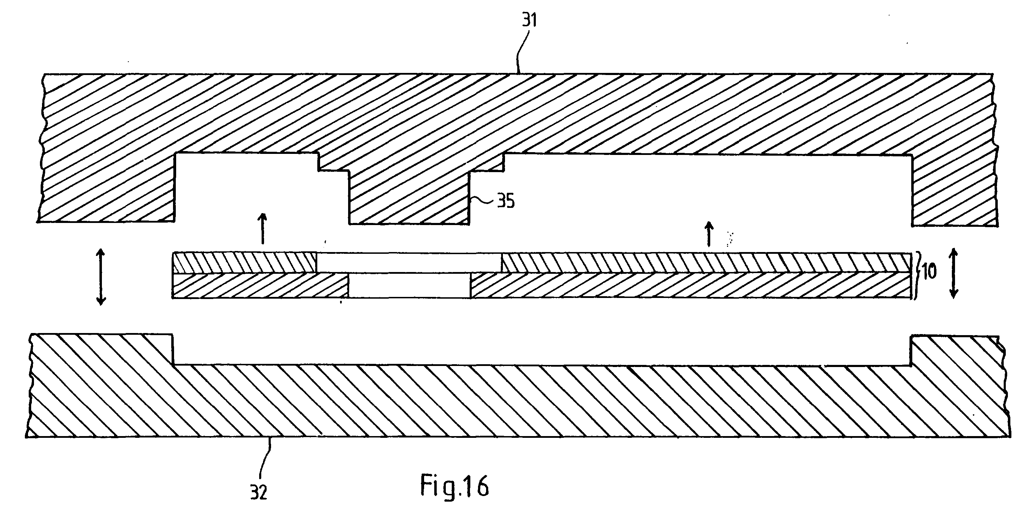

Fig.16 zeigt das Spritzgußwerkzeug mit auseinandergefahrenenen Formhälften (31,32). Der zweistufig ausgebildete Stempel (35) ist dabei einstückig mit dem Wandbereich (31A) einer Formhälfte (31) verbunden.

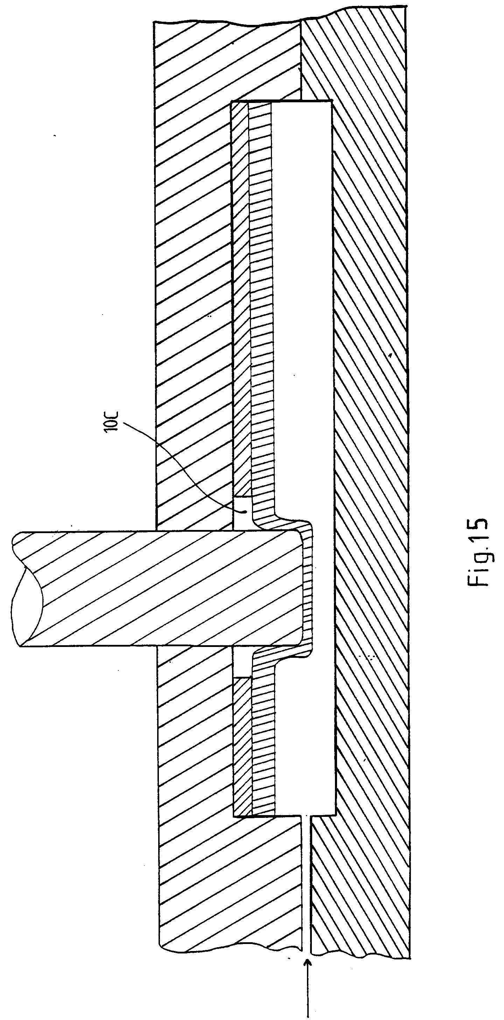

Fig.15 zeigt eine weitere Alternative zur Ausbildung einer Vertiefung in der angespritzten Kartenschicht (11). Die Spulenträgerschicht (10A) des Zwischenerzeugnisses (10) weist in diesem Fall keine Aussparung zur Aufnahme des Chipmoduls auf. Lediglich die Deckschicht (10B) weist eine Aussparung (10B0) auf. In diesem Fall, wird nach dem Einlegen des Zwischenerzeugnisses (10) in den Formraum (33), die Spulenträgerschicht (10A) im Bereich der Aussparung (10B0) der vorderseitigen Deckschicht (10B) unter Ausbildung einer Vertiefung durch den Stempel (35) unter dem Einfluß von Druck und Wärme plastisch verformt (Tiefziehverfahren).

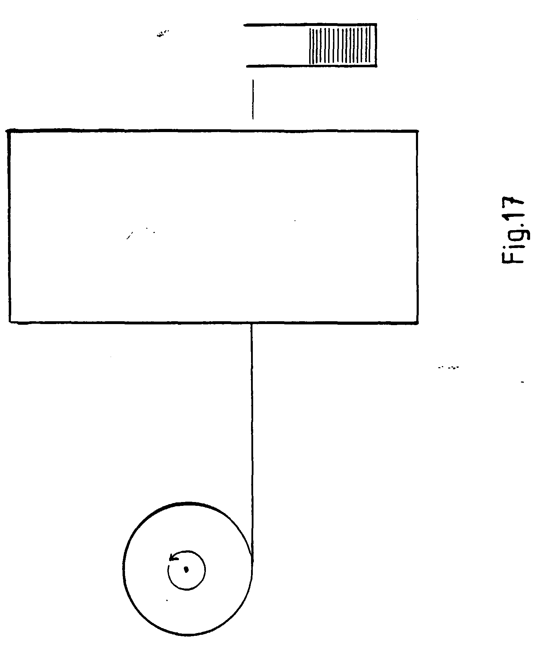

Die Zwischenerzeugnisse liegen vorteilhafter Weise als Mehrfachnutzen in einem Bogen oder auf einer Rolle für die Weiterverarbeitung vor. Das Spritzgußwerkzeug weist dabei mehrere Formräume zur Aufnahme von mehreren als Mehrfachnutzen vorliegenden Zwischenerzeugnissen auf. In Fig.17 ist schematisch dargestellt, wie die Zwischenerzeugnisse von einer Rolle dem Spritzgußwerkzeug zugeführt werden. Die Zuführvorrichtungen für die auf der Rolle angeordneten Zwischenerzeugnisse sind nicht eingezeichnet.

Die Oberläche der Spulenträgerschicht wird auf der der Spule abgewandten Seite vor dem Einlegen in die Spritzgußform einer Oberflächen-Aktivierungsverfahren unterzogen, um die Haftung mit der anzuspritzenden rückseitigen Kartenschicht (Stabilisatorschicht) zu erhöhen. Dabei kann es sich um ein Ätzverfahren oder eine Coronabehandlung handeln. Auch das Aufbringen eines Haftvermittlers ist vorgesehen.

Als Material für die anzuspritzende Kartenschicht kommen beispielsweise thermisch nicht rekristallisierende Polyester, ABS (Acrylnitril/Butadien/Styrol), PC (Polycarbonat) oder PVC (Polyvinylchlorid) in Betracht. Bei der Wahl des Materials wird jeweils auch das Material der Spulenträgerschicht berücksichtigt.

## Patentansprüche

1. Verfahren zur Herstellung einer Chipkarte in Form eines mehrschichtigen Kunststoff-Kartenkörpers (1) bestehend aus
- einer Spulenträgerschicht (10A) mit einer darauf angeordneten Spule.(10A0) sowie Anschlußstellen (Spulenenden, 10A1 ) zur elektrischen Kontaktierung der Spule (10A0) mit einem Chipmodul (2),
- einer vorderseitigen, auf der Spulenträgerschicht (10A) spulenseitig angeordneten Deckschicht (10B) mit einer Aussparung (10B0) zur Aufnahme des Chipmoduls (2), wobei die Lage und Größe der Aussparung (10B0) so ausgebildet ist, daß die An schlußstellen (10A1) der Spule (10A0) innerhalb der Aussparung (10B0) liegen,
- einer rückseitigen auf der Spulenträgerschicht (10A) angeordenten Kartenschicht (Stabilisatorschicht, 11),
dadurch gekennzeichnet, daß
ein Zwischenerzeugnis (10), bestehend aus
- der Spulenträgerschicht (10A) mit der darauf angeordneten Spule (10A0) und den Anschlußstellen (10A1) zur elektrischen Kontaktierung der Spule (2) mit dem Chip modul (2)
- und der, auf der Spulenträgerschicht (10A) angeordneten, vorderseitigen Deckschicht (10B),
in den Formraum (33) einer Spritzgußform (3) eingelegt wird, dessen Dimensionierung der des zu fertigenden Kartenkörpers (1) entspricht, wobei das Zwischenerzeugnis (10) mit der vorderseitgen Deckschicht (10B) an einem der beiden großfächigen Wandbereiche (31A) des Formraumes (33) anliegt,
und in das verbleibende Restvolumen des Formraumes (33) schmelzflüssiges Kunststoffmaterial für die rückseitige Kartenschicht (Stabilisatorschicht, 11) zur Ausbildung des fertigen Kunststoff-Kartenkörpers (1) eingespritzt wird.

2. Verfahren nach Anspruch 1,
dadurch gekennzeichnet, daß
die Spulenträgerschicht (10A) eine Aussparung (10A2) zur Aufnahme von zumindest einem Teilbereich des Chipmoduls (2) aufweist, wobei die Aussparung (10B0) in dervorderseitigen Deckschicht (10B) und die Aussparung (10A2) in der Spulenträgerschicht (10) zusammen eine stufenförmige Vertiefung (10C) in dem Kartenkörper (1) ergeben,
und die durch die Aussparung (10A2) in der Spulenträgerschicht (10A) gebildete Öffnung durch einen, in den Formraum (33) hineinragenden, Stempel (35), der sich von dem Wandbereich (31A) erstreckt, an dem das Zwischenerzeugnis (10) anliegt, vollständig geschlossen wird, so daß das in das verbleibende Restvolumen des Formraumes (33) eingespritzte, schmelzflüssige Kunststoffmaterial nicht in den Bereich der stufenförmigen Vertiefung (10C) eindringt.

3. Verfahren nach Anspruch 2,
dadurch gekennzeichent, daß
die Länge des Stempels (35) in dem Formraum (33) größer oder gleich der Dicke des Zwischenerzeungisses (10) ist, so daß die Stirnseite des Stempels (35) aus der Spulenträgerschicht (10A) hinausragt oder zumindest bündig mit dieser abschließt.

4. Verfahren nach Anspruch 3,
dadurch gekennzeichnet, daß,
nach der Entnahme des Kunststoff-Kartenkörpers (1) aus der Spritzgußform (3), in die angespritzte, rückseitige Kunststoffschicht (Stabilisatorschicht, 11) im Bereich der Spulenträgerschicht-Aussparung (10A) eine Vertiefung zur späteren Aufnahme des Chipmoduls (2) eingefräßt wird.

5. Verfahren nach einem der vorstehenden Ansprüche,
dadurch gekennzeichnet, daß
der Stempel (35) unverschiebbar im Formraum () der Spritzgußform () angeordnet ist.

6. Verfahren nach einem der vorstehenden Ansprüche,
dadurch gekennzeichnet, daß
der Stempel (35) entlang der Stempelachse gegenüber der Spritzgußform (3) verschiebbar ist, so daß die Länge des Stempels (35) in dem Formraum (33) einstellbar ist.

7. Verfahren nach einem der vorstehenden Ansprüche,
dadurch gekennzeichnet, daß
ein zweistufig ausgebildeter Stempel (35) verwendet wird, wobei die erste, äußere Stempelstirnfläche bei eingelegtem Zwischenerzeugnis (10) zur Abstützung auf der Spulenträgerschicht (10A) aufliegt, und die zweite innere Stempelstirnfläche aus der Spulenträgerschicht (10A) herausragt oder zumindest bündig mit dieser abschließt.

8. Verfahren nach einem der vorstehenden Ansprüche,
dadurch gekennzeichnet, daß
der zweistufig ausgebildte Stempel (35) von zwei gegeneinander verschiebbaren Stempeln - einem inneren Stempel (35A) und einem äußeren Stempel (35B) - gebildet ist.

9. Verfahren nach Anspruch 8,
dadurch gekennzeichnet, daß
der äußere Stempel (35A) und der innere Stempel (35B) gegenüber der Spritzgußform (3) verschiebbar sind.

10. Verfahren nach Anspruch 8,
dadurch gekennzeichnet, daß
der äußere Stempel (35A) gegenüber der Spritzgußform (3) unverschiebbar und nur der innere Stempel (35B) gegenüber der Spritzgußform (3) verschiebbar ist.

11. Verfahren nach Anspruch 1,
dadurch gekennzeichnet, daß,
nach dem Einlegen des Zwischenerzeugnisses (10) in den Formraum, die Spulenträgerschicht (10A) im Bereich der Aussparung (10B0) der vorderseitigen Deckschicht (10B) zur Ausbildung einer Vertiefung für das Chipmodul (2) durch einen Stempel (35) unter dem Einfluß von Druck und Wärme plastisch verformt wird.

12. Verfahren nach Anspruch 1,
dadurch gekennzeichnet, daß,
bei dem in die Spritzgußform (3) eingelegten Zwischenerzeugnis (10), die Spulenträgerschicht (10A) im Bereich der Aussparung der vorderseitigen Deckschicht (10B) durch einen mit seiner Stirnfläche aufliegenden Stempel (35A) abgestützt wird.

13. Verfahren nach einem der vorstehenden Ansprüche,
dadurch gekennzeichnet, daß
in den Formraum (33) zusätzlich zu dem Zwischenerzeugnis (10) und diesem beabstandet gegenüberliegend eine Overlay-Folie (12) eingelegt wird, welche an dem zweiten, großflächigen Wandbereich (31B) des Formraumes (33) anliegt, wobei das schmelzflüssige Kunststoffmaterial zur Ausbildung der Stabilisatorschicht (11) in den Raum zwischen dem Zwischenerzeugnis (10) und der Overlay-Folie (11) eingespritzt wird.

14. Verfahren nach einem der vorstehenden Ansprüche,
dadurch gekennzeichnet, daß
die Oberfläche der Spulenträgerschicht (10A) auf der der Spule (10A0) abgewandten Seite vor dem Einlegen in die Spritzgußform einer Oberflächen-Aktivierungsverfahren unterzogen wird, um die Haftung mit der anzuspritzenden rückseitigen Kartenschicht (Stabilisatorschicht, 11) zu erhöhen.

15. Verfahren nach Anspruch 14,
dadurch gekennzeichnet, daß
die Spulenträgerschicht-Oberfläche einem Ätzverfahren unterzogen wird.

16. Verfahren nach Anspruch 14,
dadurch gekennzeichnet, daß
die Spulenträgerschicht-Oberfläche einer Coronabehandlung unterzogen wird.

17. Verfahren nach Anspruch 14,
dadurch gekennzeichnet, daß
auf die Spulenträgerschicht-Oberfläche ein Haftvermittler aufgebracht wird.

18. Verfahren nach einem der vorstehenden Ansprüche,
dadurch gekennzeichent, daß
als anzuspritzendes Kunststoffmaterial das Material aus dem auch die Spulenträgerschicht (10A) besteht verwandt wird.

19. Verfahren nach einem der vorstehenden Ansprüche,
dadurch gekennzeichnet, daß
als anzuspritzendes Kunststoffmaterial ein anderes Material verwandt wird als das der Spulenträgerschicht (10A) besteht.

20. Verfahren nach einem der vorstehenden Ansprüche,
dadurch gekennzeichnet, daß
als anzuspritzendes Kunststoffmaterial ein thermisch nicht rekristallisierndes Polyester verwandt wird.

21. Verfahren nach einem der Ansprüche 1 bis 19,
dadurch gekennzeichnet, daß
als anzuspritzendes Kunststoffmaterial ABS verwandt wird.

22. Verfahren nach einem der Ansprüche 1 bis 19,
dadurch gekennzeichnet, daß
als anzuspritzendes Kunststoffmaterial PVC verwandt wird.

23. Verfahren nach einem der Ansprüche 1 bis 19,
dadurch gekennzeichnet, daß
als anzuspritzendes Kunststoffmaterial PC verwandt wird.

24. Verfahren nach einem der vorstehenden Ansprüche,
dadurch gekennzeichnet, daß
als anzuspritzendes Kunststoffmasse aus verschiedenen Kunststoffen verwandt wird.

25. Verfahren nach einem der vorstehenden Ansprüche,
dadurch gekennzeichnet, daß
das Spritzgußwerkzeug mehrere Formräume zur Aufnahme von mehren in Mehrfachnutzen angeordneten Zwischenerzeugnissen aufweist.
